# EUROPEAN PATENT APPLICATION

(11) **EP 2 477 333 A1**
(43) Date of publication of application: **18.07.2012**
(21) Application number: 10196837.8
(22) Date of filing: 23.12.2010
(51) Int. Cl.: H03J 1/00, H04H 60/65

(54) **Broadcasted program playback method**

(71) Applicant: Harman Becker Automotive Systems GmbH, 76307 Karlsbad (DE)
(72) Inventor: Hess, Wolfgang, 76307 Karlsbad (DE); Wenckebach, Ulrich, 76185 Karlsruhe (DE); Jamil, Momin, 76307 Karlsbad (DE)
(74) Representative: Patentanwälte Westphal, Mussgnug & Partner

(57) **Abstract**

A broadcast program playback method is disclosed herein that comprises of receiving from a broadcasting station a multitude of programs that include program type information; receiving from a user instructions with which programs are selected or deselected for playback; creating for a particular program type a user preference model by evaluating the user instructions that relate to this particular program type, the preference model outputs a preference indicator; and if a particular program of this particular program type is broadcasted by the broadcasting station and if the preference model indicates a user's preference for this particular program type, selecting the particular program for playback.

## Description

### BACKGROUND

### 1. Field of Technology

The invention relates to the field of receiving radio or television broadcasts and, in particular, to a broadcasted program playback method.

### 2. Related Art

By a radio broadcast is herein meant the transmission of sound to the public via electrical signals that are radiated or sent through a cable. Conventionally, several transmitting stations radiate their respective radio broadcasts at the same time in separate frequency bands. A radio receiver, selectively receives one of the radio receiver, then, the broadcasts in its particular frequency band and regenerates sound from the received broadcast.

Similarly, by a television broadcast is herein meant the transmission of sound and pictures to the public via electrical signals that are radiated or sent through a cable. Conventionally, several transmitting stations radiate their respective television broadcasts at the same time in separate frequency bands called channels. A television receiver selectively receives one of the broadcasts in its particular channel and regenerates sound and pictures from the received broadcast.

Each radio and television broadcast is comprised of a series of "programs" that may be spaced-apart in time by respective "program breaks". By a program break is herein meant any description of normal program by commercials, announcements, or other similar items.

One particular problem for a person who wishes to listen to radio programs or watch television programs that are broadcasted at specific times such as news updates, traffic reports, weather reports, or the like, is to tune in the right station at the right time. For example, a radio station broadcasts news programs every hour and a listener is used to listen to this particular news program daily at seven o'clock in the morning. If the station is tuned in too late, this person may miss some interesting or even important news. If the station is tuned in too early, content such as program break content material may be delivered which a listener may find uninteresting or boring. Furthermore, this exemplary listener may not wish to hear the news at any other time of the day and, thus, would have to watch the time which may be distractive, in particular when driving a car.

Accordingly, there is general need to provide a novel method for playback of broadcasted programs by which these attention and annoyance problems are overcome.

### SUMMARY

A broadcast program playback method described herein comprises of receiving from a broadcasting station a multitude of programs that include program type information; receiving from a user instructions with which programs are selected or deselected for playback; creating for a particular program type a user preference model by evaluating the user instructions that relate to this particular program type, the preference model outputs a preference indicator; and if a particular program of this particular program type is broadcasted by the broadcasting station and if the preference model indicates a user's preference for this particular program type, selecting the particular program for playback.

These and other objects, features and advantages of the present invention will become apparent in the detailed description of the best mode embodiment thereof, as illustrated in the accompanying drawings. In the figures, like reference numerals designate corresponding parts.

### BRIEF DESCRIPTION OF THE DRAWINGS

FIG. 1 is an illustration of an exemplary situation to which the method described herein is applicable;
FIG. 2 is a diagram illustrating exemplary program schemes of three radio stations;
FIG. 3 is an illustration of the bit placement and coding of the B-Block of an RDS/RBDS protocol;
FIG. 4 is a table that lists the RDS and RBDS Program Type (PTY) codes and their meanings;
FIG. 5 is a block diagram of a system that implementing the method described herein;
FIG. 6 is a schematic diagram illustrating the basic functions of the system of FIG. 5; and
FIG. 7 is a block diagram illustrating a Bayesian network that is applicable to the method described herein.

### DETAILED DESCRIPTION

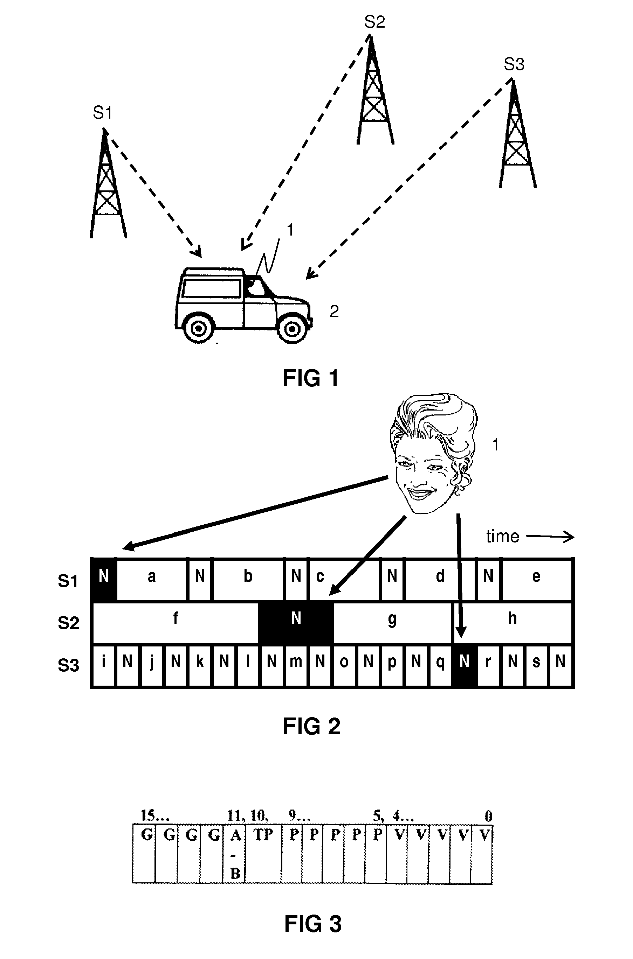

FIG. 1 illustrates an exemplary situation in which a person, e.g., a listener 1, who is driving a motor vehicle, e.g., car 2, wishes to listen to radio programs that are broadcasted at specific times on specific radio stations S1, S2, S3. Listener 1 prefers to listen, for instance, to various news programs of the radio stations S1, S2, and S3 each at certain times. Which one of the radio stations S1, S2, and S3 the listener 1 prefers or is able to receive at all, may also depend on the current position of the car 2. Accordingly, the listener 1 has to tune in the right station (which may depend on the position of the car) with the right program at the right time.

For example, the radio station S1 broadcasts, as shown in FIG. 2, news programs "N" every hour for a quarter of an hour. The rest of the program scheme is filled with programs a―e of program types other than news. Radio station S2 broadcasts once a day a news program "N" for 45 minutes. The rest of the program scheme is filled with programs f-h of program types other than news. Radio station S3 broadcasts news program on a half-hourly basis with non-news content i-s in between. The listener 1 may be used to listen to a particular one (X1) of the news programs "N" of station S1, the only one (X2) news program "N" of station S2 and to a particular one (X3) of the news programs "N" of station S3. The listener 1 may not wish to hear the news at any other time of the day and, thus, has to watch the time which may be distractive, in particular when driving the car 2. If the station is tuned in too late, this person may miss some interesting or even important news. If the station is tuned in too early, content such as program break material may be delivered that is uninteresting or boring to the listener.

In this situation, the method described herein offers support for the listener 1. When receiving any program from any radio station available by means of one or more radio receivers, the content received is classified into different radio program types by means of, for example, an Electronic Program Guide (EPG) received via Digital Audio Broadcasting (DAB) as defined in European Telecommunications Standards Institute (ETSI) TS 102 818, or in case of analog broadcasts the Radio Data Systems (RDS) as illustrated in FIG 3. The Radio Data Systems (RDS) was developed in Germany in the 1980s as an outgrowth of a traffic alerting system. It is widespread throughout Europe, and was introduced into the US in 1993 where it is known as Radio Broadcast Data System (RBDS).

RDS uses a low data rate digital subcarrier at 57 kHz to transmit data such as a station's call letters or program type (Jazz, etc.) along with the main radio signal. There is also a provision for sending 32 or 64 character text messages, referred to as "Radio Text". The RBDS standard is created and published by the National Radio Systems Committee (NRSC), formed jointly by the National Association of Broadcasters (NAB) and the Consumer Electronics Manufacturers Association (CEMA), a division of the Electronics Industry Association (EIA). The RBDS standard is a derivative of the RDS standard published by the European Broadcasting Union, headquartered in Geneva, Switzerland, as CENELEC EN50067.

The RDS data stream consists of 16-bit blocks called A, B, C, and D, which are transmitted sequentially in endless repetition. Each block carries a specific data type, which is defined by the RDS protocol. The block A (also referred to as A-Blocks) always carries the radio station ID, blocks B (B-blocks) contain control information, the block C (C block) carries either station ID or data, and the blocks D (D-blocks) contain data. Each specific arrangement of A, B, C and D blocks is called a group, of which there are 32 types, divided into 16 type A groups, and 16 type B groups.

The RDS and RBDS standards define specific meanings or applications for several of these groups, while several groups remain unused and undefined. The first four bits of the B block defines to the group number of the possible 16 groups within a group type, and the next bit defines if it is a group type A (bit 5=0) or a group of type B (bit 5=1). Group types are referred to with the notation 0A, 0B through 15A, 15B. The distinguishing character of group type B is that the station ID from the A-Block is duplicated in the C-block of the group, making this slot unavailable for data. In the US, the station ID serves no purpose. The Group Type determines the application, and thereby the definition of all the variable bits in the B-Block. The Group Types and applications of primary interest to broadcasters in the US include: 0A, Alternate Frequency and Program Service Name (Slogan); 2A & 2B, Radio Text; 10A, Program Type Name (PTYN); and 0B & 15A, Program Service Name (Slogan).

Only one or two applications can be defined by an individual Group Type, that matter being determined by whether the C-and D-Blocks will be used for the same application, or whether the C-Block will carry one application while the D-Block will carry another. As an example, the Group 0A has two applications, one in which the C-Block carries Alternate Frequency information, and one in which the D-block carries Program Service information (also called Slogan). Two individual bits in the B block are used for highway traffic announcement related indicators (the TP bit, and the TA bit). The TP bit assignment is common to all group types, while the TA bit assignment is only defined in three of the group types. FIG. 3 illustrates the bit placement and coding of the B-Block of an RDS/RBDS protocol, in which G is the Group Type, AIB is the Group Type A or B, TP is the Traffic Program, P is the Program Type (PTY) and V is a Variable Dependent on Group Type.

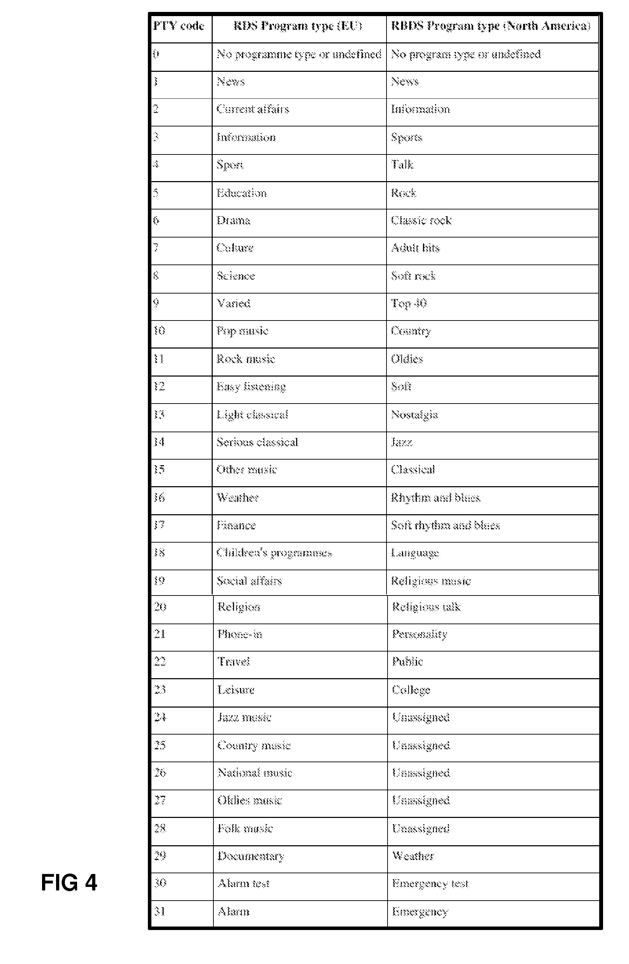

The radio stations can identify themselves as one, but only one, of the 32 categories of Program Types using the PTY bits as listed in FIG. 4. Thus, a radio station could define itself as a Rock station, and a listener using an RDS receiver designed to scan for stations by format would be able to find this station. If during a news, weather, or sports announcement the station wished to be found by scanning, they could change their PTY to one of news, weather, or sports. If the station had selected news, and a listener was scanning at that moment for news, the station would be found. However, once the station changes its PTY from Rock to News, other receivers searching for Rock stations will not discover it until it changes back. Thus, a station can use RDS to identify itself (or its current program) by anyone of the available Program Types, specifying a music format (Rock, Classical, Jazz, etc.), or a non-musical program format (News, Weather, or Sports), but only one at a time; and if the station is classified by anything other than what a listener is scanning for, it won't be found.

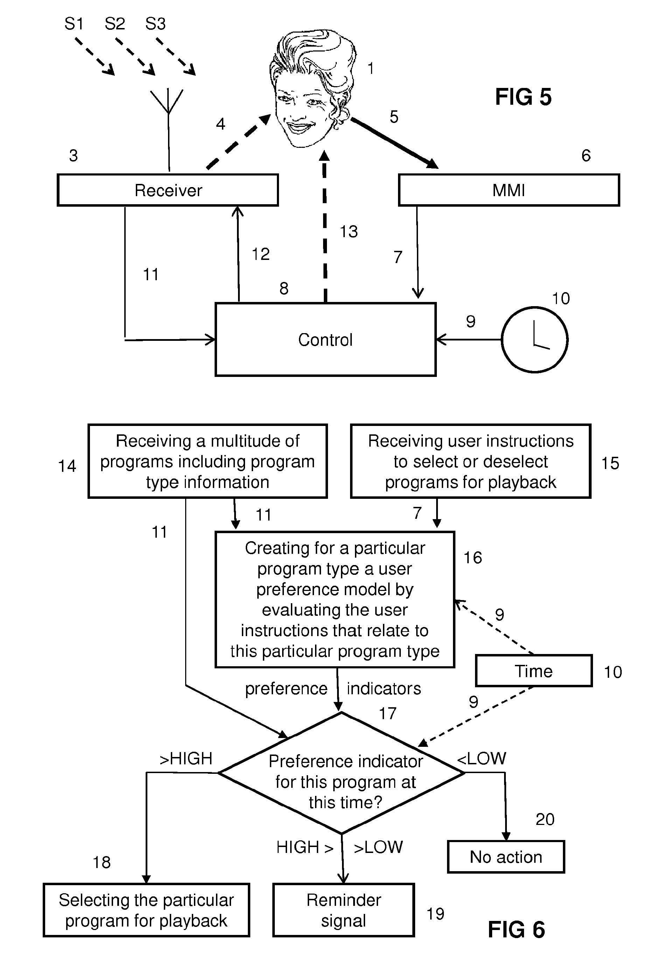

Referring to the system shown in FIG. 5, a radio receiver unit 3 including a single, double or even triple receiver arrangement and having RDS processing capabilities receives broadcasted programs from the radio stations S1, S2 and S3 simultaneously, successively or as a blend of both. One of the received (audio) programs is presented to the listener 1 as sound 4 reproduced by a loudspeaker (not shown for the sake of simplicity). The listener has either (a) actively chosen the current program or (b) enjoys/tolerates/ignores the current program or (c) switches, i.e. skips, to another program. Respective instructions 5 by the listener 1 are input into a man machine interface (MMI) 6 that supplies a user instruction signal 7 to a control unit 8. The control unit 8 further receives a time signal 9 from a timer 10 providing a representation of at least the time of the day and a program identification signal 11 which may include at least one of program type information (PTY), the station identification and the broadcast frequency of the particular station. The control unit 8 provides to the receiver unit 3 a control signal 12 with which at least tuning of one of the receivers is performed and, furthermore, an acoustic and/or optical signal 13 (reminder signal), e.g., signaling sound, signaling light etc., with which the listener 1 is informed that a news program is available.

FIG. 6 illustrates schematically the basic processes performed in the system of FIG. 5. This system receives in a process 14 a multitude of programs at least sequentially or in case of a multi-receiver arrangement even simultaneously. The programs each include program type information and, maybe, other information contained, e.g., in the RDS messages described with reference to FIG. 3. The system further receives in a process 15 the instructions of the user 1 which may be divided into select instructions (e.g., the user has actively chosen the current program) or deselect instructions (e.g., the user skips a program being currently reproduced). A further category may include indefinite instructions such as no action by the user when a certain program is played. The reason for the inactiveness of the listener 1 may be, for instance, that she or he likes the current program or does not take notice of the program or tolerates the program even if not amused.

In a process 16, the program identification signal 11, e.g., the program type information (and additionally or alternatively the broadcast frequency or station identification etc.) of the current program or a program to be played is linked to the corresponding user instruction signal 7 and, as the case may be, the related time signal 9 such that, for a certain program type, station or broadcast frequency (e.g., news program or news station) at a specific time an initial preference indicator is increased (e.g., by "1") when a selecting user instruction occurs, or is decreased (e.g., by "1") when a deselecting user instruction occurs. Indefinite user instructions are not considered in this example.

Thus, a list or table is formed that provides for a certain program or program type at a certain time of the day and a preference indicator that represents a measure of the user's preference for a particular program or type of program. When this program or this type of program is broadcasted by the tuned station (or one of the tuned stations in case of a multi-receiver arrangement), the system may compare, in a process 17, the preference indicator with certain thresholds (HIGH, LOW) and depending on this comparison may select the preferred program for playback (process 18) when the preference is above the threshold HIGH or may provide specific acoustic and/or optical signal (process 19) when the preference is above the threshold LOW but below the threshold HIGH or may take no action (process 20) when the user preference indicator is below the threshold LOW.

Generally, the processes illustrated in FIG. 6 can be split into a 'learning phase' or an 'executing phase'. The learning phase may include processes 14, 15 and 16 - 'executing phase' may include processes 14, 17, 18, 19 and 20.

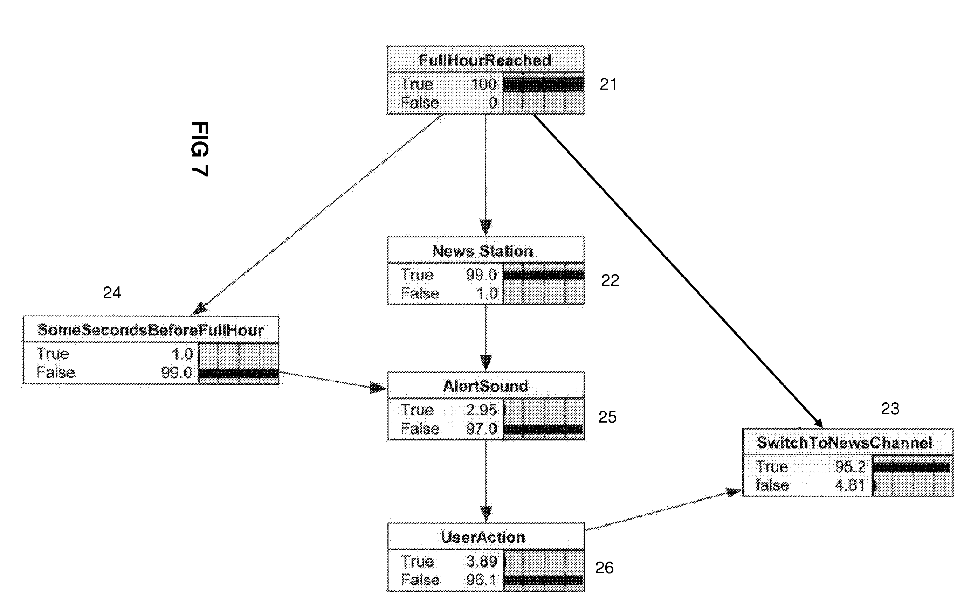

Alternatively to the method shown in FIG. 6, a so-called Bayesian network as illustrated with reference to FIG. 7 may be used in order to decide what action is to be taken. A Bayesian network, also known as belief network or directed acyclic graphical model, is a probabilistic graphical model that represents a set of random variables and their conditional dependencies via a directed acyclic graph (DAG). Formally, Bayesian networks are directed acyclic graphs whose nodes represent random variables in the Bayesian sense: they may be observable quantities, latent variables, unknown parameters or hypotheses. Edges represent conditional dependencies; nodes which are not connected represent variables which are conditionally independent of each other. Each node is associated with a probability function that takes as input a particular set of values for the node's parent variables and gives the probability of the variable represented by the node. For example, if the parents are Boolean variables then the probability function could be represented by a table of entries, one entry for each of the possible combinations of its parents being true or false. Generalizations of Bayesian networks that can represent and solve decision problems under uncertainty are known as influence diagrams.

In FIG. 7 an exemplary Bayesian network is shown in which in a process 21 it is observed whether, for instance, the full hour (e.g., 07:00 a.m.) has been reached or not. If so, the system checks if the current station is a news station (in a function block 22) or switches to a specific news station as, e.g., a news channel (in a process 23). If the full hour has not been reached, yet, it is checked (process 24 whether there are some seconds left to full hour or not. If so and if there is currently no news station tuned in (as checked in process 22), an optical and/or acoustic signal such as an alert sound is generated and presented to a user (process 25). Upon this alert sound, (in a process 26) the user may initiate switching to the news channel (process 23) or may react in another manner or may not react at all. Exemplary likelihoods for each option "true" and "false" in each one of the processes 21-26 are also shown in FIG.

The system shown in FIGS. 6 and 7 may have a default setting which is active when no user preference model is available (e.g., initial setting) and which provides the optical and/or acoustic signal (reminder signal) when one or more broadcast stations broadcast a program of the particular program type. The user may train the system by switching to the news upon occurrence of this 'reminder' signal. Thus, the system learns (not only) to provide the reminder signal when news program is available but also to switch automatically to the news program. The training may be refined with respect to certain times of the day such that it switches to the news program only at certain times of the day. For example, the system may be trained to behave as follows:
A) If the listener (almost) never switches to the news program shortly before or during broadcast of the news program, neither a reminder signal is provided nor automatically switching is performed by the system;
B) If the listener sometimes switches to the news program shortly before or during broadcast of the news program, the reminder signal is provided;
C) If the listener frequently switches to the news program upon provision of the reminder signal, the system automatically switches to the news program;
D) If the listener frequently switches to programs other than news programs upon provision of the news program, neither a reminder signal is provided nor automatically switching is performed by the system.

Although the present invention has been illustrated and described with respect to several preferred embodiments thereof, various changes, omissions and additions to the form and detail thereof, may be made, without departing from the spirit and scope of the invention.

## Claims

1. A broadcast program playback method comprising
receiving from a broadcasting station a multitude of programs that include program type information;
receiving from a user instructions with which programs are selected or deselected for playback;
creating for a particular program type a user preference model by evaluating the user instructions that relate to this particular program type, the preference model outputs a preference indicator; and
if a particular program of this particular program type is broadcasted by the broadcasting station and if the preference model indicates a user's preference for this particular program type, selecting the particular program for playback.

2. The method of claim 1, in which the programs are received simultaneously from a magnitude of broadcasting stations and in which, if a particular program of this particular program type is broadcasted by a particular one of the broadcasting stations and if the preference model indicates a user's preference for this particular program type, the particular program from the particular station is selected for playback.

3. The method of claim 1 or 2, in which the preference model utilizes the time of the day when the particular program type is broadcasted by each one of the broadcasting stations from which programs are received.

4. The method of claim 3, in which the preference model utilizes the day of the week on which the particular program type is broadcasted by each one of the broadcasting stations from which programs are received.

5. The method of one of claims 1-4, in which the preference model utilizes the user instructions prior to and during broadcast of a program of the particular program type.

6. The method of one of claims 1-5, in which the preference model utilizes the broadcasting station which broadcasts the particular program of the particular program type.

7. The method of one of claims 1-6, in which each broadcasting station is assigned to types of broadcasting stations and in which the preference model utilizes the type of broadcasting station which broadcasts the particular program of the particular program type.

8. The method of one of claims 1-7, in which at least one broadcasting station broadcasts additionally radio data system (RDS) information and in which the program type information is the program type (PTY) information included in the radio data system (RDS) information.

9. The method of one of claims 1-8, in which the preference model utilizes a Bayesian network to determine the preference indicator from a frequency with which a user selects or deselects a program or program type.

10. The method of one of claims 1-9, further comprising, upon selection of the particular program for playback, providing an optical and/or acoustic signal for the user or reproducing the particular program or both.

11. The method of claim 10, in which neither the optical and/or acoustic signal is provided nor the program is reproduced if the user preference model indicates that the frequency with which the user switches to programs of the particular program type is below a first threshold.

12. The method of claim 10 or 11, in which the optical and/or acoustic signal is provided if the user preference model indicates that the frequency with which the user switches to programs of the particular program type prior to or during such programs is above a second threshold.

13. The method of claim 10, 11 or 12, in which the particular program is reproduced if the user preference model indicates that the frequency with which the user switches to programs of the particular program type upon provision of the optical and/or acoustic signal is above a third threshold.

14. The method of one of claims 10-13, in which neither the optical and/or acoustic signal is provided nor the particular program is reproduced if the user preference model indicates that the frequency with which the user switches to a program of a type other than the particular program type when the optical and/or acoustic signal is provided or program of the particular type is reproduced, is above a forth threshold.

15. The method of one of claims 10-14, further comprising a default setting which is active when no user preference model is available and which provides the optical and/or acoustic signal when one or more broadcast stations broadcast a program of the particular program type.
